# EUROPÄISCHE PATENTSCHRIFT

(11) **EP 3 439 044 B1**
(45) Veröffentlichungstag und Bekanntmachung des Hinweises auf die Patenterteilung: **06.09.2023**
(21) Anmeldenummer: 18185156.9
(22) Anmeldetag: 24.07.2018
(51) Int. Cl.: H01L 29/08, H01L 29/78, H01L 27/02, H01L 29/808, H01L 29/06

(54) **MONOLITHISCH INTEGRIERTER HALBLEITERSCHALTER, INSBESONDERE LEISTUNGSTRENNSCHALTER**
MONOLITHIC INTEGRATED SEMICONDUCTOR, IN PARTICULAR ISOLATING SWITCH
COMMUTATEUR À SEMI-CONDUCTEUR INTÉGRÉ MONOLITHIQUE, EN PARTICULIER COMMUTATEUR DE SÉPARATION DE PUISSANCE

(30) Priorität: 03.08.2017 DE 102017213489
(43) Veröffentlichungstag der Anmeldung: 06.02.2019
(73) Patentinhaber: Fraunhofer-Gesellschaft zur Förderung der angewandten Forschung e.V., 80686 München (DE)
(72) Erfinder: Hürner, Andreas, 90459 Nürnberg (DE); Erlbacher, Tobias, 91099 Poxdorf (DE)
(74) Vertreter: Gagel, Roland

(56) Entgegenhaltungen:
- CN-B- 103 280 458
- ANDREAS HUERNER ET AL: "Monolithically Integrated Solid-State-Circuit-Breaker for High Power Applications", MATERIALS SCIENCE FORUM, Bd. 897, 1. Mai 2017 (2017-05-01), Seiten 661-664, XP055533727, DOI: 10.4028/www.scientific.net/MSF.897.661
- MATTHAEUS ALBRECHT ET AL: "Experimental Verification of a Self-Triggered Solid-State Circuit Breaker Based on a SiC BIFET", MATERIALS SCIENCE FORUM, Bd. 897, 1. Mai 2017 (2017-05-01), Seiten 665-668, XP055533730, DOI: 10.4028/www.scientific.net/MSF.897.665

## Beschreibung

### Technisches Anwendungsgebiet

Die vorliegende Erfindung betrifft einen monolithisch integrierten Halbleiterschalter, insbesondere einen Leistungstrennschalter, mit einem monolithisch integrierten Feldeffekttransistor, bei dem ein Source- oder Emitter-Gebiet des Feldeffekttransistors mit einem ersten elektrischen Anschluss und ein Drain- oder Kollektor-Gebiet des Feldeffekttransistors mit einem zweiten elektrischen Anschluss des Halbleiterschalters elektrisch verbunden sind.

Halbleiterschalter werden als Leistungstrennschalter beispielsweise zur Begrenzung und Abschaltung eines Überstromes in einem elektrischen Netzwerk genutzt. Bei Auftreten eines Kurzschlusses innerhalb eines elektrischen Netzwerkes wird der Laststrom lediglich von der Impedanz des Netzwerkes begrenzt. Es entsteht ein Überstrom, aus dem eine signifikante thermische Belastung der angeschlossenen Lasten resultiert. Um eine sich hieraus ergebende Beschädigung dieser Lasten zu vermeiden, ist eine schnelle Begrenzung und Abschaltung des Überstromes erforderlich, bei der unter anderem auch die Zündung von Lichtbögen vermieden werden sollte.

### Stand der Technik

In der Energieübertragungstechnik wurde diese Problematik bisher typischerweise durch Verwendung mechanischer Leistungstrennschalter gelöst. Diese Leistungstrennschalter werden zum Ein- und Ausschalten von Betriebsströmen sowie zum Abschalten von Kurzschlussströmen im Fehlerfall eingesetzt. Im Normalbetrieb müssen sie sowohl alle Betriebsströme führen als auch den dabei auftretenden thermischen und dynamischen Beanspruchungen standhalten. Im Kurzschlussfall muss der Leistungstrennschalter den Strompfad möglichst abrupt und sicher abschalten, damit nachfolgende Betriebsmittel nicht geschädigt oder zerstört werden. Die Trennstelle muss dabei eine durchschlagsichere Isolierstrecke zwischen den benachbarten Leitern bilden.

Bei mechanischen Leistungstrennschaltern werden die Schaltstücke im Störfall über einen mechanischen Hebel voneinander getrennt. Dabei wird die Stromdichte im Kontaktbereich so groß, dass sich eine Schmelzbrücke bildet. Der daraus zwischen den Kontakten entstehende Lichtbogen hält den Stromkreis zunächst geschlossen. Im Wechselstrom erlischt der Lichtbogen beim Spannungsnulldurchgang. Damit der Lichtbogen jedoch beim Wiederanstieg der Spannung nicht erneut zündet, muss die Lichtbogenstrecke entionisiert werden. Dies wird durch Kühlung des Lichtbogens mittels eines Löschmittels wie Beispiel SF₆ oder durch Vakuum erzielt. Der Schaltvorgang kann mehrere Zyklen andauern. Während des Abschaltvorganges steigt der Strom rapide an und nähert sich abhängig von der Abschaltdauer der Amplitude des Stoßstromes immer weiter an. Die Größe der Amplitude ist von der Netzstruktur und der darin zur Verfügung stehenden Kurzschlussleistung abhängig. Die Gesamtzeit von der Detektion bis zur vollständigen Trennung des Strompfades kann dabei weit über 100ms andauern. Innerhalb dieser Periode fließt der Überstrom durch die nachfolgenden Betriebsmittel, die aufgrund dessen auch für diesen Überstrom dimensioniert werden müssen. Um die Überstrombelastung zu reduzieren, müsste der Leistungsschalter schneller abschalten. Jedoch verstärkt ein zu schneller Schaltvorgang bei mechanischen Leistungstrennschaltern die Lichtbogenintensität, wodurch zusätzliche Energie zum Löschen benötigt wird und der Verschleiß der Kontakte voranschreitet. Daher ist es schwer, mit mechanischen Schaltern kurze Schaltzeiten zu erreichen.

Eine weitere Möglichkeit zur Lösung der obigen Problematik stellt die Verwendung halbleiterbasierter Leistungstrennschalter dar. Diese Schalter sind in der Lage, in einigen Mikrosekunden abzuschalten. Zudem bilden sie keinen Lichtbogen aus, so dass kein zusätzliches Löschmittel benötigt wird. Aufgrund fehlender beweglicher Teile sind sie verschleiß- und wartungsarm und durch ihren kompakten Aufbau auch platzsparend. Grundsätzlich besteht ein derartiger Leistungstrennschalter aus mehreren parallel oder in Serie geschalteten Einzelbauelementen, insbesondere Thyristoren, GTOs und IGBTs. Da Leistungstrennschalter in dieser Anwendung überwiegend im Ein-Zustand betrieben werden, können Schaltverluste und Sperreigenschaften in erster Näherung unberücksichtigt bleiben. Folglich sind IGBTs aufgrund ihrer signifikant höheren Durchlassverluste im Vergleich zu Thyristoren ungeeignet. Thyristoren scheinen sich aufgrund ihrer geringen Durchlassverluste besser zu eignen und sind für Sperrspannungen bis 8kV erhältlich. Das Zünden erfolgt durch einen geringen Gatestrom oder durch einen Lichtimpuls. Zum Löschen muss ein bestimmter Haltestrom unterschritten werden. Dies erfolgt bei Wechselstrom durch Überschreiten des Nulldurchgangs selbsttätig. Jedoch ist eine gewisse Freiwerdezeit einzuhalten, in welcher die verbleibenden Ladungsträger aus der Raumladungszone ausgeräumt werden. Dies kann bis zu mehreren 100µs dauern. Während dieser Zeit muss der Wiederanstieg der Spannung begrenzt werden, da ansonsten der Thyristor spontan wieder gezündet wird. Die Freiwerdezeit verlängert sich allerdings durch Anstieg des Vorwärtsstromes oder bei steigender Temperatur. Weiterhin ist zu beachten, dass der Thyristor aufgrund des Nulldurchgangs ein kontinuierliches Zündsignal erfordert. Im Gegensatz dazu können Gate-Turn-Off-Thyristoren (GTO) durch einen rückwärtigen Steuerstrom abgeschaltet werden. Dies kann jedoch nicht allein durch den internen Aufbau des Halbleiters erreicht werden, sondern bedarf einer zusätzlichen RCD-Beschaltung, um beim Abschalten den Wiederanstieg der Spannung zu begrenzen. Problematisch bei derartigen Leistungsschaltern ist, dass keine galvanische Trennung in Sperrbetrieb besteht. Selbst im Sperrbetrieb fließen immer noch geringe Sperrströme im mA-Bereich.

Aus M. Callaviket al., "The Hybrid HVDC Breaker. ABB Grid System", Technical Paper Nov. 2012, ist ein hybrider Leistungsschalter für die Gleichstromübertragung bekannt. Dabei handelt es sich um eine Parallelschaltung aus einem Bypass und dem aus Leistungshalbleitern aufgebauten elektrischen Leistungstrennschalter, der den Hauptschalter bildet. Im Normalbetrieb fließt der Strom durch den Bypass. Dieser setzt sich aus einem schnell schaltenden mechanischen Leistungsschalter und einem Kommutator zusammen. Im Störfall bewirkt der Kommutator eine Erhöhung des Leitungswiderstandes, so dass der Strom zum Hauptstrompfad kommutiert. Der Kommutator wird durch in Serie geschaltete IGBTs verwirklicht, welche den Leitungswiderstand mittels Änderung der Gatespannung erhöhen. Nach einer kurzen Zeitverzögerung öffnet sich der mechanische Schalter. Der Strom wird nun vom Hauptschalter unterbrochen. Der gesamte Abschaltvorgang dauert unter 5ms. Jedoch ist der komplette Aufbau sehr aufwändig und teuer.

Ein grundsätzliches Problem der vorangehend erläuterten Lösungsansätze stellt der komplexe Aufbau der Leistungstrennschalter dar. Dieser bedarf einer umfangreichen Ansteuerelektronik, die letztlich zu einer Einschränkung der Zuverlässigkeit des Gesamtsystems führt.

Aus B. Rosensaft et al., "Circuit Breaker and Safe Controlled Power Switch", Proc. of the 19th International Symposium on Power Semiconductor Devices & ICs, Korea 2007, S. 169-172, ist ein monolithisch integrierter Leistungstrennschalter mit einem n-JFET und einem p-JFET bekannt, der nach dem Prinzip des so genannten dualen Thyristors aufgebaut ist. Bei dieser Verschaltung sind die Source-Elektroden beider JFETs miteinander, die Gate-Elektrode des p-JFET mit dem Anodenanschluss und die Gate-Elektrode des n-JFET mit dem Kathodenanschluss kurzgeschlossen. Analog zu einem Thyristor, der nach dem Überkopfzünden einen hohen Stromfluss mit niedriger Flussspannung aufrechterhält, kann der duale Thyristor nach dem Auslösen eine hohe Sperrspannung mit minimalem Sperrstrom halten. Während der selbsthaltende Thyristor mittels Nulldurchgang der Spannung gelöscht wird, erfolgt das (Wieder-)Einschalten des dualen Thyristors, auch unter dem Begriff SSCB (Solid State Circuit-Breaker) bekannt, durch einen Nulldurchgang des Stroms. Im Gegensatz zum Thyristor ist beim SSCB anstelle des Überkopfzündens durch eine zu hohe Sperrspannung das Überkopfsperren mittels zu hoher Stromstärke möglich. Damit kann dieses Bauelement als selbstauslösendes rücksetzbares Sicherungselement bei Kurzschlüssen und Überströmen der elektrischen Energieübertragung eingesetzt werden. Im Normalfall fließt der Phasenstrom über den niederohmigen Leistungstrennschalter. Im Fehlerfall schaltet der Leistungstrennschalter innerhalb einiger 100ps in einen hochohmigen Zustand und nimmt dabei die volle Phasenspannung dauerhaft (bis zum Rücksetzen) auf.

Allerdings sind bei einem derartigen Leistungsbauelement die maximale Kathodenspannung von der Sperrfestigkeit der Gate-Elektrode des n-JFET sowie die maximale Anodenspannung von der Sperrfestigkeit der Gate-Elektrode des p-JFET begrenzt. Damit eignet sich ein derartig aufgebauter Leistungsschalter lediglich für kleine Betriebsspannungen, insbesondere bei einer monolithischen Integration. Die Gatepotentiale der JFETs werden dabei ausschließlich über Halbleitergebiete angesteuert, so dass eine Ansteuerung über die Gate-Elektroden von außen nicht möglich ist. Für höhere Betriebsspannungen wurden in der genannten Veröffentlichung von Rosensaft et al. auch Abwandlungen eines derartigen Leistungstrennschalters gezeigt, die im Wesentlichen auf der Prozesstechnologie des MOSbasierten IGBTs mit einem monolithisch integrierten n-Kanal MOSFET basieren.

In der nachveröffentlichten DE 10 2016 207 859 ist ein monolithisch integrierter Halbleiterschalter mit regenerativem Abschaltverhalten beschrieben, der sich als Leistungs- oder Lasttrennschalter auch bei hohen Betriebsspannungen einsetzen lässt und eine schnelle automatische Abschaltung bei Überströmen ermöglicht. Dieser Halbleiterschalter besteht aus zwei Feldeffekttransistoren, deren Steuerungsprinzip wenigstens für einen der Feldeffekttransistoren dem Steuerungsprinzip eines JFET entspricht. Die Source- oder Emitter-Elektrode des ersten Feldeffekttransistors ist dabei mit der Source- oder Emitter-Elektrode des zweiten Feldeffekttransistors kurzgeschlossen. Die Drain- oder Kollektor-Elektrode des ersten Feldeffekttransistors ist mit einem ersten elektrischen Anschluss des Halbleiterschalters, die Drain- oder Kollektor-Elektrode des zweiten Feldeffekttransistors mit einem zweiten elektrischen Anschluss des Halbleiterschalters verbunden. Das Wannengebiet des zweiten Feldeffekttransistors ist mit den beiden Source- oder Emitter-Elektroden der beiden Feldeffekttransistoren kurzgeschlossen. Das Wannengebiet des ersten Feldeffekttransistors ist mit dem zweiten elektrischen Anschluss kurzgeschlossen. Das Kanalgebiet der Feldeffekttransistoren liegt jeweils zwischen der Gate-Elektrode und dem Wannengebiet. Für diesen Halbleiterschalter ist jedoch mindestens ein JFET mit p-dotiertem Kanalgebiet notwendig. Damit ist aufgrund der niedrigen Leitfähigkeit p-dotierter Schichten mit einem relativ hohen Einschaltwiderstand und damit sehr hohen Verlusten im Normalbetrieb zu rechnen.

Aus der CN 103 280 458 B ist eine ESD-Schutzeinrichtung mit einem MOS Transistor bekannt, bei der der Substratwiderstand zwischen dem Source-Gebiet und dem Substrat-Kontakt kostengünstig erhöht werden soll. Bei dieser Schutzeinrichtung sind hierzu mehrere n-dotierte Gebiete unter dem ersten elektrischen Anschluss ausgebildet. Jedes n-dotierte Gebiet ist über einen n-dotierten Kanal mit dem Source-Gebiet verbunden. Die n-dotierten Kanäle verlaufen zwischen p-dotierten Gebieten.

Die Aufgabe der vorliegenden Erfindung besteht darin, einen Halbleiterschalter anzugeben, der sich als Leistungs- oder Lasttrennschalter auch bei hohen Betriebsspannungen einsetzen lässt, eine schnelle automatische Abschaltung bei Überströmen ermöglicht und geringe Durchlassverluste im Normalbetrieb aufweist.

### Darstellung der Erfindung

Die Aufgabe wird mit dem monolithisch integrierten Halbleiterschalter gemäß Patentanspruch 1 gelöst. Vorteilhafte Ausgestaltungen des Halbleiterschalters sind Gegenstand der abhängigen Patentansprüche oder lassen sich der nachfolgenden Beschreibung sowie den Ausführungsbeispielen entnehmen.

Bei dem vorgeschlagenen Halbleiterschalter mit einem monolithisch integrierten Feldeffekttransistor ist das Source- oder Emitter-Gebiet des Feldeffekttransistors über ein Halbleitergebiet und ein n-dotieres Kontaktgebiet mit einem ersten elektrischen Anschluss und das Drain- oder Kollektor-Gebiet des Feldeffekttransistors mit einem zweiten elektrischen Anschluss des Halbleiterschalters elektrisch verbunden. In dem Halbleitergebiet zwischen dem n-dotierten Kontaktgebiet und dem Source- oder Emitter-Gebiet des Feldeffekttransistors ist beim vorgeschlagenen Halbleiterschalter eine Halbleiterstruktur mit n-dotierten Kanälen ausgebildet, die das n-dotierte Kontaktgebiet mit dem Source- oder Emitter-Gebiet des Feldeffekttransistors elektrisch verbinden und zwischen p-dotierten Gebieten verlaufen, die - vorzugsweise über eine ohmsche Verbindung - mit dem n-dotierten Kontaktgebiet verbunden sind.

Bei diesem Aufbau des Halbleiterschalters bildet die Halbleiterstruktur zwischen dem n-dotierten Kontaktgebiet und dem Source- oder Emitter-Gebiet des Feldeffekttransistors einen stromabhängigen Vorwiderstand für den Feldeffekttransistor. Im Normalbetrieb fließt dabei der Strom vom n-dotierten Kontaktgebiet zur Source- oder Emitter-Gebiet des Feldeffekttransistors und wird somit ausschließlich durch die zwischen den beiden elektrischen Anschlüssen, d.h. zwischen Anode und Kathode, anliegende Spannung und durch den Widerstand der n-dotierten Kanäle bestimmt. Aufgrund der im Vergleich zur Leitfähigkeit p-dotierter Schichten hohen Leitfähigkeit n-dotierter Bereiche wird eine deutliche Reduzierung des Einschaltwiderstandes und der Verluste im Normalbetrieb gegenüber dem Halbleiterschalter der DE 10 2016 207 859 erreicht. Bei Strömen über dem Nennstrom resultiert jedoch ein zusätzlicher Spannungsabfall über den n-dotierten Kanälen. Dies führt zu einer Abschnürung dieser Kanäle durch eine Raumladungszone und dadurch zu einer Erhöhung des Widerstands dieser Kanäle. Diese Erhöhung des Widerstands führt bei ausreichend hohem Widerstand schließlich zu einer vollständigen Abschnürung des n-dotierten Kanalgebiets des JFET. Damit wird der gesamte Halbleiterschalter bei entsprechend hoher Anoden- und Kathodenspannung ausgeschaltet und erfüllt somit die Aufgabe als Last- bzw. Leistungstrennschalter.

Die p-dotierten Gebiete der Halbleiterstruktur sind über eine ohmsche Verbindung mit dem Source- oder Emitter-Gebiet ohmsch verbunden. Dadurch kann der Strom im Normalbetrieb auch durch die p-Gebiete der Halbleiterstruktur fließen, um die Stromtragfähigkeit des Halbleiterschalters weiter zu erhöhen. Diese ohmsche Verbindung wie auch die vorzugsweise ohmsche Verbindung mit dem n-dotierten Kontaktgebiet kann in unterschiedlicher Weise entweder in Form mehrerer separater Verbindungen oder als durchgehender Verbindungsstreifen, der quer zu den n-dotierten Kanälen verläuft, ausgebildet sein. Die ohmsche Verbindung wird dabei durch eine Metallisierung gebildet. Im Falle der ohmschen Verbindung zu dem n-dotierten Kontaktgebiet kann diese auch durch eine Verlängerung der Metallisierung der Kathode gebildet sein.

Die n-dotierten Kanäle müssen nicht notwendigerweise parallel zueinander verlaufen oder einen konstanten Querschnitt aufweisen. Sie können sich bspw. auch in Richtung des n-dotierten Kontaktgebietes aufweiten, d.h. ihren Querschnitt vergrößern.

Vorzugsweise weist der Halbleiterschalter als monolithisch integrierten Feldeffekttransistor einen n-JFET auf. Prinzipiell sind jedoch auch andere Feldeffekttransistoren, wie bspw. ein im Normalzustand leitender oder nichtleitender p-Kanal MOSFET oder ein BIFET möglich. Im Falle des BIFET weist der Halbleiterschalter ein p-Substrat anstelle des n-Substrates beim n-JFET auf. Durch die Nutzung eines p-dotierten Kollektorgebietes beim BIFET werden im eingeschalteten Zustand zusätzliche Ladungsträger in das Driftgebiet injiziert. Hierdurch lassen sich niedrige statische Verluste auch bei sehr hohen Sperrfestigkeiten realisieren.

Bei dem vorgeschlagenen Halbleiterschalter wird der Feldeffekttransistor vorzugsweise in einem Halbleitersubstrat aus Silizium oder Siliziumkarbid monolithisch integriert. Durch den Einsatz von Siliziumkarbid ergibt sich die Möglichkeit, Halbleiterbauelemente für den Betrieb bei hohen Sperrspannungen zu realisieren, so dass auch Anwendungen des vorgeschlagenen Halbleiterschalters in der Mittelspannungsebene (10kV bzw. 20kV) und in der HGÜ-Technik in Frage kommen. Während in der Mittelspannungsebene eine Funktionalität bei Wechselspannung (mit Polaritätswechsel) gegeben sein muss, bedarf es bei der HGÜ-Technik nur eines Betriebs bei einer Polarität. Im Gegensatz zu mechanischen Trennschaltern weist der vorgeschlagene Halbleiterschalter vor allem eine hohe Auslösegeschwindigkeit auf.

Durch die monolithische Integration eines spannungsabhängigen Vorwiderstandes in den vorgeschlagenen Halbleiterschalter kann der Stromfluss über dem Halbleiterschalter beim Überschreiten einer bestimmten Anoden-Spannung oder dem Überschreiten eines bestimmten Anoden-Stroms automatisch abgeschaltet werden. Eine zusätzliche Ansteuer- und Überwachungselektronik ist hierfür nicht erforderlich. Die Grenzwerte für die Anoden-Spannung und den Anoden-Strom lassen sich durch die Dimensionierung der einzelnen Halbleitergebiete festlegen. Bei Realisierung mit getrennt ansteuerbarer Gate-Elektrode - anstelle einer elektrischen Verbindung der Gate-Elektrode mit der Kathode - können die Grenzwerte auch im Betrieb beeinflusst werden.

Durch den vorgeschlagenen Aufbau des monolithisch integrierten Halbleiterschalters kann die Problematik des zugrundeliegenden Konzeptes der DE 10 2016 207 859, bei dem das Potential auf der Anode auch auf dem Gate-Potential des p-JFET liegt, gelöst werden. Somit wird die maximale Sperrfestigkeit des monolithisch integrierten Halbleiterschalters nicht mehr durch die maximale an die Gate-Elektrode anlegbare Spannung, sondern durch die Dimensionierung des Driftgebietes im Feldeffekttransistor bestimmt. Durch entsprechende Wahl der Dicke und Dotierung des Driftgebietes lassen sich mit dem vorgeschlagenen Aufbau somit monolithisch integrierte Leistungstrennschalter mit Sperrfestigkeiten von bis zu 6,5 kV (Silizium) bzw. 100 kV (Siliziumkarbid) realisieren.

Der vorgeschlagene Halbleiterschalter kann bspw. zur Sicherung elektrischer Netze und Anlagen eingesetzt werden. Er eignet sich zur Sicherung von Gleichspannungsanlagen, beispielsweise zur Energieübertragung in Gebäuden oder zur Energieversorgung von elektrischen Antrieben aus einem Gleichspannungszwischenkreis, und auch für andere Anwendungen.

### Kurze Beschreibung der Zeichnungen

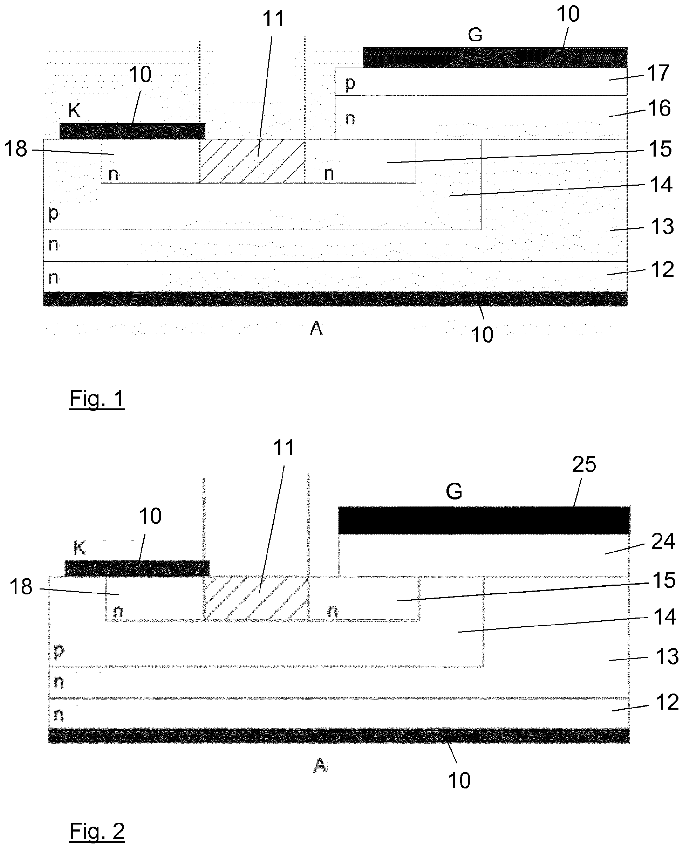

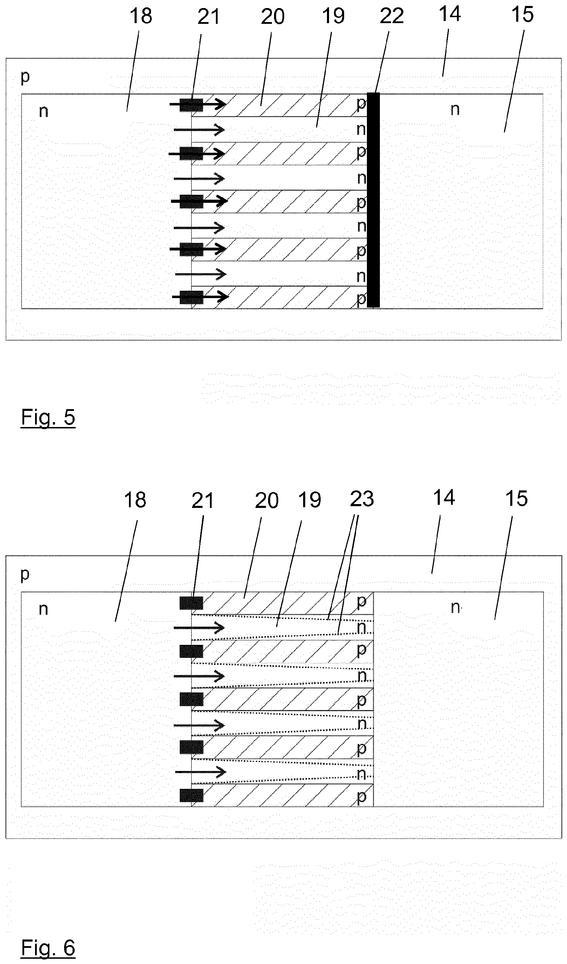

Der vorgeschlagene Halbleiterschalter wird nachfolgend anhand von Ausführungsbeispielen in Verbindung mit den Zeichnungen nochmals näher erläutert. Hierbei fällt das in Fig. 5 gezeigte Ausführungsbeispiel unter den Anspruch 1, während die Ausführungsbeispiele der Fig. 1-4 und 6 die beanspruchte ohmsche Verbindung der p-dotierten Gebiete mit dem Source- oder Emitter-Gebiet nicht enthalten. Hierbei zeigen:
- Fig. 1: eine schematische Darstellung eines Beispiels des vorgeschlagenen Halbleiterschalters mit einem SiC-n-JFET mit lateralem Kanal;
- Fig. 2: eine schematische Darstellung eines Beispiels des vorgeschlagenen Halbleiterschalters mit einem p-Kanal MOSFET;
- Fig. 3: ein Beispiel für die Ausgestaltung des Halbleitergebietes mit den n-dotierten Kanälen beim vorgeschlagenen Halbleiterschalter in Draufsicht;
- Fig. 4: eine schematische Darstellung des Stromflusses in der Halbleiterstruktur der Figur 3 im Normalbetrieb ;
- Fig. 5: eine schematische Darstellung einer weiteren Ausgestaltung der Halbleiterstruktur des vorgeschlagenen Halbleiterschalters in Draufsicht mit den im Normalbetrieb fließenden Strömen;
- Fig. 6: eine schematische Darstellung der Stromrichtung sowie der Ausbreitung der Raumladungszone in der Halbleiterstruktur der Figur 3 bei Strömen über dem Nennstrom;
- Fig. 7: ein Beispiel für den Einsatz des erfindungsgemäßen Leistungstrennschalters als Schutzvorrichtung bei Überströmen in einer Netzanwendung; und
- Fig. 8: ein Beispiel für einen Einsatz des erfindungsgemäßen Leistungstrennschalters in einer hybriden Anordnung.

### Wege zur Ausführung der Erfindung

Der vorgeschlagene Halbleiterschalter weist einen monolithisch integrierten Feldeffekttransistor mit einem stromabhängigen Vorwiderstand auf, der durch eine Halbleiterstruktur mit n-dotierten Kanälen gebildet ist, die das n-dotierte Kontaktgebiet mit dem Sourceoder Emitter-Gebiet des Feldeffekttransistors elektrisch verbinden und zwischen p-dotierten Gebieten verlaufen. Figur 1 zeigt hierzu die schematische Darstellung eines Beispiels der monolithischen Integration des stromabhängigen Vorwiderstandes in einem SiC-n-JFET mit lateralem Kanal. Der n-JFET ist hierbei in ein n-dotiertes Substrat 12 monolithisch integriert und weist ein n-dotiertes Kontaktgebiet 18, ein n-dotiertes Sourcegebiet 15 in einer p-dotierten Wanne 14 sowie einen n-dotierten Kanal 16, ein p-dotiertes Gategebiet 17 und ein n-dotiertes Driftgebiet 13 auf, wie dies aus der Figur 1 ersichtlich ist. Es ist auch die Realisierung eines selbstleitenden JFET durch Grabengates anstelle von p-Gebieten möglich. Die beiden elektrischen Anschlüsse des Halbleiterschalters werden durch die Metallisierungen 10 der Kathode K über dem n-dotierten Kontaktgebiet 18 und der Anode A auf der Rückseite des n-dotierten Substrates 12 gebildet. Die Halbleiterstruktur 11 zwischen dem n-dotierten Sourcegebiet 15 und dem n-dotierten Kontaktgebiet 18 stellt den stromabhängigen Vorwiderstand dar und wird durch n-dotierte Kanäle 19 zwischen p-dotierten Gebieten 20 gebildet. Die n-dotierten Kanäle 19 werden im Folgenden auch als n-Source-Streifen bezeichnet, die p-dotierten Gebiete 20 als p-dotierte Streifen.

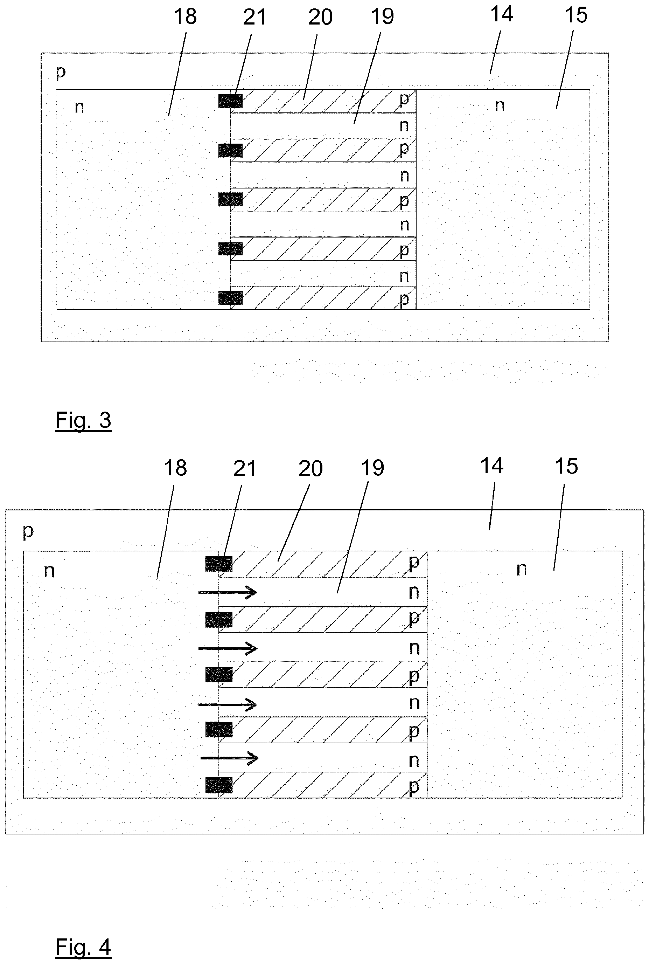

Figur 3 zeigt eine Draufsicht auf diese beispielhafte Ausgestaltung des Halbleiterschalters, in der das n-dotierte Kontaktgebiet 18, das n-dotierte Sourcegebiet 15 und die den spannungsabhängigen Vorwiderstand bildende Halbleiterstruktur innerhalb der p-Wanne 14 in Draufsicht schematisch dargestellt sind. Der spannungsabhängige Vorwiderstand besteht aus den n-Source-Streifen 19, die das n-dotierte Sourcegebiet 15 mit dem n-dotierten Kontaktgebiet 18 ohmsch verbinden, sowie p-dotierte Streifen 20, die in diesem Beispiel durch eine ohmsche Schicht 21 ohmsch mit dem n-dotierten Kontaktgebiet 18 verbunden sind. Die p-dotierten Streifen 20 können dabei entweder von der p-Wanne 14 selbst gebildet, durch eine zusätzliche Epitaxieschicht gebildet oder durch eine zusätzliche Implantation hergestellt werden.

Figur 2 zeigt eine schematische Darstellung eines weiteren Beispiels des vorgeschlagenen Halbleiterschalters, bei dem anstelle des n-JFET ein im Normalzustand nicht-leitender oder leitender MOSFET integriert ist. Das in Figur 1 dargestellte n-dotierte Kanalgebiet 16 und das p-dotierte Gategebiet 17 werden dabei durch einen Isolator 24 (Gateoxid) und die Gateelektrode 10 durch eine Polysilizium-Schicht 25 ersetzt. Das Funktionsprinzip des Halbleiterschalters dieser Ausgestaltung ist analog dem der Figur 1. Im Unterschied zu diesem ist bei der Verwendung eines im Normalzustand nicht-leitfähigen MOSFET jedoch eine Gate-Ansteuerung notwendig. Diese erlaubt gleichzeitig eine Änderung des Auslösestroms im Normalbetrieb.

Figur 4 zeigt schematisch durch Pfeile den im Normalbetrieb in dem beispielhaften Halbleiterschalter der Figur 1 fließenden Elektronenstrom vom n-dotierten Kontaktgebiet 18 zum n-dotierten Sourcegebiet 15. Der Strom, der durch die Pfeile in der Figur 4 angedeutet ist, fließt durch die n-Source-Streifen 19 und wird somit ausschließlich durch die zwischen Anode und Kathode anliegende Spannung und den Widerstand der n-Source-Streifen 19 bestimmt. Der Strom durch diesen Vorwiderstand kann direkt in den n-JFET weiterfließen (Elektronenstrom), so dass keine zusätzliche elektrische Verbindung notwendig ist, um den Löcherstrom in einen Elektronenstrom umzuwandeln. Im Vergleich zu einem p-JFET ergibt sich aufgrund der im Vergleich zur Leitfähigkeit p-dotierter SiC-Schichten hohen Leitfähigkeit n-dotierter Schichten eine deutliche Reduzierung des Einschaltwiderstandes. Diese liegt im Bereich eines konventionellen n-JFET mit lateralem Kanalgebiet. Weiterer wesentlicher Vorteil ist die geringere Temperaturabhängigkeit des Stroms durch den n-JFET gegenüber einem p-JFET. Zur weiteren Erhöhung der Stromtragfähigkeit kann auch der Strom durch die p-dotierten Gebiete 20 der Halbleiterstruktur 11 genutzt werden. Hierzu müssen die p-dotierten Gebiete 20 mit dem n-dotierten Sourcegebiet 15 durch eine weitere Metallisierung (ohmsche Schicht 22) überbrückt werden, wie dies in der Figur 5 dargestellt ist. Hierdurch ist auch eine zumindest teilweise Kompensation der Temperaturabhängigkeiten von n-JFET und p-JFET in einem gewissen Temperaturbereich möglich, so dass die Temperaturabhängigkeit des Auslösestroms gegenüber einem reinen Elektronenstrom verringert werden kann. Diese Figur zeigt auch die korrespondierenden Ströme, die durch Pfeile angedeutet sind und in diesem Beispiel auch die p-dotierten Gebiete 20 für den Stromfluss nutzen.

Bei Strömen über dem Nennstrom resultiert bei dem vorgeschlagenen Halbleiterschalter ein für Sperrschichtfeldeffekttransistoren typischer, zusätzlicher Spannungsabfall über den n-Source-Streifen 19. Dies führt zu einer Abschnürung der n-Source-Streifen 19 durch eine Raumladungszone 23, wie dies in Figur 6 beispielhaft dargestellt ist. Die Stromrichtung ist wiederum durch Pfeile angedeutet. Die Abschnürung durch die Raumladungszone 23 erhöht den Widerstand der n-Source-Streifen 19, was bei vorgegebenem Strom zu einer Erhöhung des Spannungsabfalls über den n-Source-Streifen 19 führt. Durch diesen Spannungsabfall steigt jedoch auch das Potential am n-dotierten Sourcegebiet 15 an. Dies wiederum führt dazu, dass der Potentialunterschied zwischen dem p-dotierten Gategebiet 17 (vgl. Figur 1) und dem n-dotierten Sourcegebiet 15 negativer wird. Durch den negativen Potentialunterschied zwischen dem n-dotierten Sourcegebiet 15 und dem p-dotierten Gategebiet 17 nimmt die Weite der Raumladungszone zwischen dem p-dotierten Gategebiet 17 und dem n-dotierten Kanalgebiet 16 zu und das n-dotierte Kanalgebiet 16 wird abgeschnürt. Erreicht der Spannungsabfall über den n-Source-Streifen 19 die Abschaltspannung des n-JFET, so wird dieser und damit der gesamte Lasttrennschalter ausgeschaltet. Untersuchungen dieser Anordnung mittels numerischer Modellbildung zeigen, dass der Lasttrennschalter selbsthaltend im ausgeschalteten Zustand verbleibt.

Eine beispielhafte Auslegung der Streifen 19, 20 ist nachfolgend beschrieben. Für eine Dotierung der n-dotierten Epitaxieschicht zur Bildung der n-Source-Streifen 19 kann 6*10¹⁵cm⁻³ gewählt werden. Werden nun die p-dotierten Streifen 20 mit einer Breite von (beispielsweise) 3pm und einer Dotierung von 5*10¹⁸cm⁻³ gewählt, so kann der Vorwiderstand durch den Abstand der p-dotierten Streifen 20 zueinander so eingestellt werden, dass er bei einer gewählten Abschnürspannung hochohmig wird (und der Leistungstrennschalter auslöst). Bei einem Abstand der p-dotierten Streifen 20 von 2pm schnürt das dazwischen liegende n-Gebiet (n-Source-Streifen 19) bei einer Spannung von ca. 10V ab. Bei einem Abstand der p-dotierten Streifen 20 von 2.8pm sind hierfür bereits 20V notwendig. Sind die p-dotierten Streifen 20 bei dieser n-Dotierung weniger als 1µm voneinander beabstandet, tritt die Abschnürung bereits bei 0V auf und der Leistungstrennschalter ist stets sperrend. Für ein funktionsfähiges Bauteil muss eine solche Dimensionierung vermieden werden.

Für die Nutzung der p-dotierten Streifen 20 zur Stromleitfähigkeit muss die Dimensionierung so erfolgen, dass beide Streifen (näherungsweise) gleichzeitig ausgeräumt werden. Diese Vorgehensweise ist von Ladungskompensationsbauelementen wie "Superjunction MOSFETs", LDMOS-Transistoren und dem JTE-Randabschluss bekannt. Entsprechende Dimensionierungsvorschriften lassen sich dem einschlägigen Stand der Technik entnehmen.

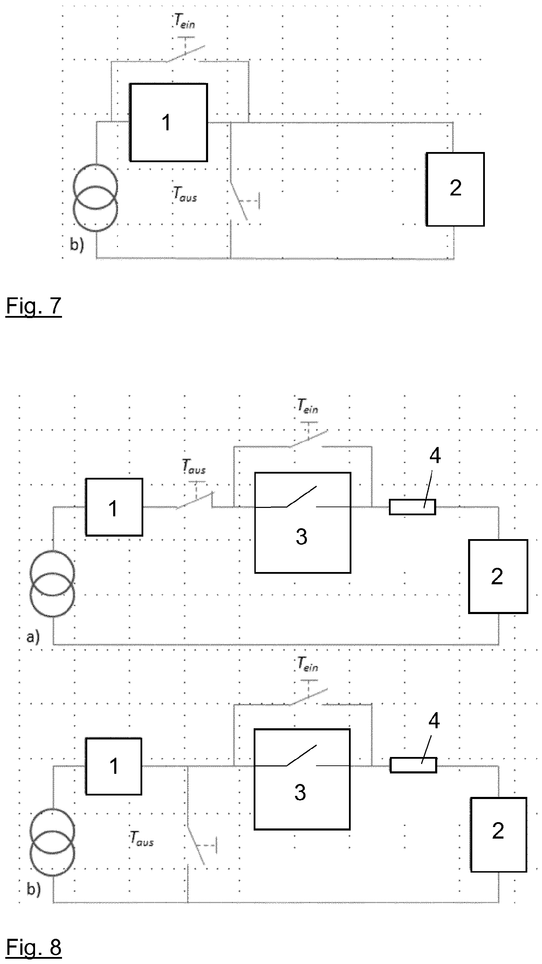

In den Figuren 7 und 8 sind beispielhafte Anwendungen des erfindungsgemäßen Leistungstrennschalters als Schutzschaltung in einem Energienetzwerk dargestellt. Die Einbindung ins Netz sowie die Ausführung der Ein-/Aus-Taster entsprechen dabei dem im jeweiligen Netz (Spannungsebene) üblichen Stand der Technik und sind hier nur symbolisch als Taster Tₑᵢₙ/Tₐᵤₛ ausgeführt. Figur 7 zeigt den vorgeschlagenen Leistungstrennschalter 1 als Schutzorgan bei Überströmen (z.B. Lastkurzschluss) in einer Netzwerkanwendung. Die Last 2 ist in dieser Figur ebenfalls schematisch dargestellt.

Die in Figur 8 dargestellte Konfiguration mit dem vorgeschlagenen Leistungstrennschalter 1 trägt der Notwendigkeit eines mechanischen Lasttrennschalters in elektrischen Energieübertragungsstrecken Rechnung. Diese ist gegebenenfalls gesetzlich vorgeschrieben und stellt eine mechanische Trennung von Netz und Last 2 sicher. Figur 8 zeigt hierzu einen hybriden Lasttrennschalter bestehend aus in diesem Beispiel selbst haltendem mechanischen oder magnetischen Schütz 3 mit einem Relais 4 und dem vorgeschlagenen Leistungstrennschalter 1. Die Last 2 ist in dieser Figur ebenfalls wieder schematisch dargestellt. Teilabbildung A zeigt die Situation mit trennendem Aus-Taster Tₐᵤₛ, Teilabbildung B mit schließendem Aus-Taster Tₐᵤₛ.

### Bezugszeichenliste

- 1: Leistungstrennschalter
- 2: Last
- 3: mechanischer/magnetischer Schütz
- 4: Relais
- 10: Metallisierung
- 11: Halbleiterstruktur
- 12: n-Substrat/Anodenbereich
- 13: n-dotiertes Driftgebiet
- 14: p-dotiertes Wannengebiet
- 15: n-dotiertes Sourcegebiet
- 16: n-dotiertes Kanalgebiet
- 17: p-dotiertes Gategebiet
- 18: n-dotiertes Kontaktgebiet
- 19: n-dotierter Kanal/Streifen
- 20: p-dotiertes Gebiet/Streifen
- 21: ohmsche Schicht
- 22: ohmsche Schicht
- 23: Raumladungszone
- 24: Isolator
- 25: Polysilizium-Schicht
- A: Anode
- G: Gate
- K: Kathode
- Tₑᵢₙ: Taster
- Tₐᵤₛ: Taster

## Patentansprüche

1. Halbleiterschalter mit einem monolithisch integrierten Feldeffekttransistor, bei dem ein Source- oder Emitter-Gebiet (15) des Feldeffekttransistors mit einem ersten elektrischen Anschluss (10, K) und ein Drain- oder Kollektor-Gebiet (12) des Feldeffekttransistors mit einem zweiten elektrischen Anschluss (10, A) des Halbleiterschalters elektrisch verbunden ist, wobei
- das Source- oder Emitter-Gebiet (15) des Feldeffekttransistors über ein Halbleitergebiet (11) und ein n-dotiertes Kontaktgebiet (18) mit dem ersten elektrischen Anschluss (10, K) verbunden ist und
- in dem Halbleitergebiet (11) zwischen dem n-dotierten Kontaktgebiet (18) und dem Source- oder Emitter-Gebiet (15) des Feldeffekttransistors eine Halbleiterstruktur mit n-dotierten Kanälen (19) ausgebildet ist, die das n-dotierte Kontaktgebiet (18) mit dem Source- oder Emitter-Gebiet (15) des Feldeffekttransistors elektrisch verbinden und zwischen p-dotierten Gebieten (20) verlaufen, die innerhalb des Halbleiterschalters mit dem n-dotierten Kontaktgebiet (18) verbunden sind,
**dadurch gekennzeichnet,**
**dass** die p-dotierten Gebiete (20) über eine ohmsche Verbindung (22) mit dem Source- oder Emitter-Gebiet (15) verbunden sind.

2. Halbleiterschalter nach Anspruch 1,
**dadurch gekennzeichnet,**
**dass** die Breite der n-dotierten Kanäle (19) so gewählt ist, dass die Halbleiterstruktur einen stromabhängigen Widerstand zwischen dem ersten elektrischen Anschluss (10, K) und dem Source- oder Emitter-Gebiet (15) des Feldeffekttransistors bilden.

3. Halbleiterschalter nach Anspruch 1 oder 2,
**dadurch gekennzeichnet,**
**dass** der Feldeffekttransistor ein n-JFET, ein MOSFET oder ein BIFET ist.

4. Halbleiterschalter nach einem der Ansprüche 1 bis 3, **dadurch gekennzeichnet,**
**dass** die p-dotierten Gebiete (20), zwischen denen die n-dotierten Kanäle (19) verlaufen, über eine ohmsche Verbindung (21) mit dem n-dotierten Kontaktgebiet (18) verbunden sind.

5. Halbleiterschalter nach einem der Ansprüche 1 bis 4, **dadurch gekennzeichnet,**
**dass** der Feldeffekttransistor ein BIFET ist und das Kollektor-Gebiet (12) p-dotiert ist.

6. Halbleiterschalter nach einem der Ansprüche 1 bis 5, **dadurch gekennzeichnet,**
**dass** der Feldeffekttransistor in einem Halbleitersubstrat aus Silicium oder Siliciumkarbid monolithisch integriert ist.

## Claims

1. Semiconductor switch with a monolithically integrated field effect transistor, in which a source or emitter region (15) of the field effect transistor is electrically connected to a first electrical connection (10, K), and a drain or collector region (12) of the field effect transistor is electrically connected to a second electrical connection (10, A) of the semiconductor switch, wherein
- the source or emitter region (15) of the field effect transistor is connected to the first electrical connection (10, K) via a semiconductor region (11) and a n-doped contact region (18), and
- a semiconductor structure with n-doped channels (19) is formed in the semiconductor region (11) between the n-doped contact region (18) and the source or emitter region (15) of the field effect transistor, which channels electrically connect the n-doped contact region (18) to the source or emitter region (15) of the field effect transistor and extend between p-doped regions (20), which are connected to the n-doped contact region (18) within the semiconductor switch,
**characterized in that**
the p-doped regions (20) are connected to the source or emitter region (15) via an ohmic connection (22).

2. Semiconductor switch according to Claim 1,
**characterized in that**
the width of the n-doped channels (19) is chosen such that the semiconductor structure forms a currentdependent resistor between the first electrical connection (10, K) and the source or emitter region (15) of the field effect transistor.

3. Semiconductor switch according to Claim 1 or 2,
**characterized in that**
the field effect transistor is a n-JFET, a MOSFET or a BIFET.

4. Semiconductor switch according to any one of Claims 1 to 3,
**characterized in that**
the p-doped regions (20), between which the n-doped channels (19) extend, are connected to the n-doped contact region (18) via an ohmic connection (21).

5. Semiconductor switch according to any one of Claims 1 to 4,
**characterized in that**
the field effect transistor is a BIFET, and the collector region (12) is p-doped.

6. Semiconductor switch according to any one of Claims 1 to 5,
**characterized in that**
the field effect transistor is monolithically integrated in a semiconductor substrate made of silicon or silicon carbide.

## Revendications

1. Commutateur monolithique comportant un transistor à effet de champ intégré monolithiquement, dans lequel une région de source ou d'émetteur (15) du transistor à effet de champ est connectée électriquement avec une première connexion électrique (10, K) et une région de drain ou de collecteur (12) du transistor à effet de champ est connectée électriquement à une deuxième connexion électrique (10, A) du commutateur monolithique, dans lequel
- la région de source ou d'émetteur (15) du transistor à effet de champ est connectée via une zone semi-conductrice (11) et une région de contact dopée n (18) à la première connexion électrique (10, K) et
- dans la région semi-conductrice (11) entre la région de contact dopée n (18) et la région de source ou d'émetteur (15) du transistor à effet de champ une structure semi-conductrice est formée avec des canaux dopés n (19), qui connectent électriquement la région de contact dopée n (18) à la région de source ou d'émetteur (15) du transistor à effet de champ et s'étendent entre des régions dopées p (20), qui sont connectées à l'intérieur du commutateur monolithique avec la région de contact dopée n (18),
**caractérisé en ce que** les régions dopées p (20) sont connectées via une connexion ohmique (22) à la région de source ou d'émetteur.

2. Commutateur monolithique selon la revendication 1,
**caractérisé en ce que**
la largeur des canaux dopés n (19) est choisie de telle sorte que la structure semi-conductrice forme une résistance dépendante du courant entre la première connexion électrique (10, K) et la région de source ou d'émetteur (15) du transistor à effet de champ.

3. Commutateur monolithique selon la revendication 1 ou 2,
**caractérisé en ce que**
le transistor à effet de champ est un n-JFET, un MOSFET ou un BIFET.

4. Commutateur monolithique selon une des revendications 1 à 3,
**caractérisé en ce que**
les régions dopées p (20) entre lesquelles s'étendent les canaux dopés n (19) sont connectées à la région de contact dopée n (18) par une connexion ohmique (21).

5. Commutateur monolithique selon une des revendications 1 à 4,
**caractérisé en ce que**
le transistor à effet de champ est un BIFET.

6. Commutateur monolithique selon une des revendications 1 à 5,
**caractérisé en ce que**
le transistor à effet de champ est intégré monolithiquement dans un substrat semi-conducteur en silicium ou en carbure de silicium.
